(19) Europäisches Patentamt
European Patent Office
Office européen des brevets

(11) EP 0 813 067 A2

(12) **EUROPÄISCHE PATENTANMELDUNG**

(43) Veröffentlichungstag:
17.12.1997 Patentblatt 1997/51

(51) Int. Cl.⁶: G01R 19/00

(21) Anmeldenummer: 97109008.9

(22) Anmeldetag: 04.06.1997

(84) Benannte Vertragsstaaten:
AT BE CH DE DK ES FI FR GB GR IE IT LI LU MC
NL PT SE

(30) Priorität: 12.06.1996 DE 19623441

(71) Anmelder:
TEMIC TELEFUNKEN microelectronic GmbH
74072 Heilbronn (DE)

(72) Erfinder:
• Fendt, Günter
86529 Schrobenhausen (DE)

• Hora, Peter
86529 Schrobenhausen (DE)
• Müller, Norbert
86529 Schrobenhausen (DE)

(74) Vertreter:
Maute, Hans-Jürgen, Dipl.-Ing.
TEMIC TELEFUNKEN microelectronic GmbH
Postfach 35 35
74025 Heilbronn (DE)

(54) **Elektronische Messschaltung, insbesondere zum Messen von Strömen, mit einem integrierten Messwiderstand**

(57) Die Erfindung betrifft eine elektronische Meßschaltung, insbesondere zum Messen von Strömen, mit einem Meßwiderstand, an dem ein einer zumessenden Größe entsprechendes Spannungssignal abgegriffen wird, und mit einem Verstärkerkreis, über den das am Meßwiderstand abgegriffene, verstärkte Spannungssignal als Meßsignal an eine Auswerte- oder Verarbeitungsschaltung angelegbar ist. Um mit einer derartigen elektronische Meßschaltung eine jeweils zu messende Größe genau erfassen zu können, ohne daß ein eigener externer Meßwiderstand erforderlich ist, ist erfindungsgemäß vorgesehen, daß der Verstärkerkreis einen steuerbaren Korrekturverstärker aufweist, dessen Verstärkungsfaktor in Abhängigkeit von der Abweichung des tatsächlichen Widerstandswertes des Meß-widerstands von seinem Nennwiderstandswert gesteuert wird.

FIG.1

EP 0 813 067 A2

## Beschreibung

Die Erfindung betrifft eine elektronische Meßschaltung, insbesondere zum Messen von Strömen, mit einem integrierten Meßwiderstand nach dem Oberbegriff des Patentanspruchs 1.

Elektronische Schaltungen, insbesondere komplexe elektronische Schaltungen werden heutzutage als integrierter Schaltkreis auf einem Halbleitersubstrat, also als IC realisiert, da auf einem IC sehr viele logische Funktionen auf kleinstem Raum untergebracht werden können. Dabei gewinnen insbesondere anwendungsspezifische integrierte Schaltkreise, sogenannte ASIC (application specific integrated circuit) immer mehr an Bedeutung.

Eine derartige Meßschaltung ist beispielsweise aus dem Artikel von Gregor Kleine: "Strommesser MAX 471/MAX 472", in: Elektro 6/95, S 31ff. zu entnehmen.

Problematisch ist es jedoch bei integrierten Schaltkreisen genaue Widerstände auf dem Halbleitersubstrat auszubilden, weil deren Genauigkeit sehr stark von den jeweiligen Parametern sowie von Fertigungstoleranzen abhängig ist. Üblicherweise haben die Widerstände auf einem integrierten Schaltkreis Toleranzen von ± 30 %.

Darüber hinaus ist der DE 195 23 182 A1 ein Abstimmschaltkreis zu entnehmen, bei dem zum Zwecke der Kompensation von Fertigungstoleranzen bei integrierten Widerständen ein Spannungsabfall über einen ebenfalls integrierten vergleichswiderstand ausgewertet wird. Die A/D-Wandlung des Vergleichssignals zur Steuerung programmierter Schaltungsteile ist jedoch verhältnismäßig aufwendig, nur in Schriften möglich und letztlich für eine einfache elektronische Meßschaltung ungeeignet.

Elektronische Meßschaltungen, bei denen ein genauer Meßwiderstand benötigt wird, lassen sich daher oft nicht oder nur mit großen Schwierigkeiten in einer integrierten Schaltung integrieren. Üblicherweise wird daher ein genauer externer Meßwiderstand mit der integrierten Schaltung verbunden und ein zu messender Strom wird dann aus der integrierten Schaltung mittels eines Stromspiegels auf den genauen externen Widerstand "herausgespiegelt". Dabei wird der an dem Meßwiderstand erzeugte Spannungsabfall erfaßt und ausgewertet.

Bei dieser Vorgehensweise ist es jedoch von Nachteil, daß der externe Widerstand zumindest in der Zeit, in der der Meßstrom über ihn geführt wird, nur noch als Meßwiderstand verwendet werden kann. Damit ist es nicht möglich, irgendeinen ohnehin für die integrierte Schaltung erforderlichen externen Widerstand, zum Beispiel den in der Regel bei jeder integrierten Schaltung zur Einstellung von internen Strömen erforderlichen Einstellwiderstand (SET-Widerstand) als Meßwiderstand zu nutzen. Somit wird für den Meßwiderstand zumindest ein weiterer Anschluß auf dem Halbleitersubstrat der integrierten Schaltung benötigt, wodurch die Herstellung der Schaltung erschwert und verteuert wird.

So weist auch die Strommeßschaltung gemäß der DE 689 04 664 T2 ausgangsseitig einen hochpräzisen externen Widerstand möglichst mit linearem Verhalten über einen großen Arbeitsbereich auf, über dem die Meßspannung abgegriffen wird. Durch ähnliche Fertigungsabweichungen der Widerstände im Operationsverstärkerkreis werden lediglich innerhalb dieser Meßfehler vermieden.

Davon ausgehend liegt der Erfindung die Aufgabe zugrunde, eine weitere elektronische Meßschaltung der eingangs genannten Art bereitzustellen, die es mit besonders einfachen schaltungstechnischen Mitteln ermöglicht, die jeweils zu messende Größe ohne Einfluß der auftretenden Fertigungstoleranzen über einem integrierten Meßwiderstand genau zu erfassen, ohne daß zusätzlich ein externer Meßwiderstand erforderlich wird.

Diese Aufgabe wird durch die elektronische Meßschaltung nach Anspruch 1 gelöst.

Erfindungsgemäß ist also ein Korrekturverstärker vorgesehen, dessen Verstärkungsfaktor in Abhängigkeit von der jeweiligen tatsächlichen Fertigungstoleranz des in der integrierten Schaltung vorgesehenen Meßwiderstandes gesteuert wird. Hierzu wird die Genauigkeit eines ohnehin für die integrierte Schaltung erforderlichen genauen externen Widerstandes (SET-Widerstand) in die auf dem Halbleitersubstrat realisierte integrierte Schaltung mittels eines Stromspiegels im Vergleich zu einem internen Vergleichswiderstand "hineingespiegelt", d.h. ein mittels des genauen externen Widerstands genau festgelegter Strom wird auf einen internen, also auf dem Halbleitersubstrat vorgesehenen Vergleichswiderstand gespiegelt, so daß sich die jeweilige konkrete Fertigungstoleranz, also die Abweichung des tatsächlichen Widerstandswertes eines konkreten Vergleichswiderstandes von seinem Nennwiderstandswert ermitteln läßt. Damit läßt sich der Verstärkungsfaktor eines erfindungsgemäß vorgesehenen Korrekturverstärkers entsprechend der jeweiligen tatsächlichen Herstellungstoleranz des Vergleichswiderstandes, die mit der Herstellungstoleranz des Meßwiderstandes identisch ist, einstellen.

Der dabei genutzte externe Widerstand (SET-Widerstand) wird weiterhin nur in einem Arbeitspunkt und nicht etwa, wie bei Meßwiderständen üblich in einem großen Arbeitsbereich betrieben, wodurch die Anforderungen der Widerstandskennlinie gleich bleiben. Ein besserer, teurer SET-Widerstand ist nicht erforderlich. Gegebenenfalls kann die Bedtimmung der relativen Abweichung auch durch einen Konstantstrom erfolgen.

Durch die erfindungsgemäße Ausbildung der Meßschaltung wird nicht nur erreicht, daß ein zusätzlicher genauer externer Widerstand (externer Meßwiderstand zusätzlich zum externen SET-Widerstand) nicht benötigt wird, sondern es kann auch ein hierfür erforderlicher Anschlußpin entfallen. Damit lassen sich die Herstellungs- und Bestückungskosten einer elektronischen Schaltungsanordnung verringern.

Vorteilhafte Ausgestaltungen und Weiterbildungen der Erfindung sind in den Unteransprüchen beschrieben.

Die Erfindung wird im folgenden beispielsweise anhand der Zeichnung näher erläutert. Es zeigen:

Fig. 1    ein schematisches, vereinfachtes Schaltbild einer erfindungsgemäßen Meßschaltung und

Fig. 2    ein schematisches, vereinfachtes Schaltbild einer anderen erfindungsgemäßen Meßschaltung in Bipolartechnik.

In den verschiedenen Figuren der Zeichnung sind einander entsprechende Bauteile mit gleichen Bezugszeichen versehen.

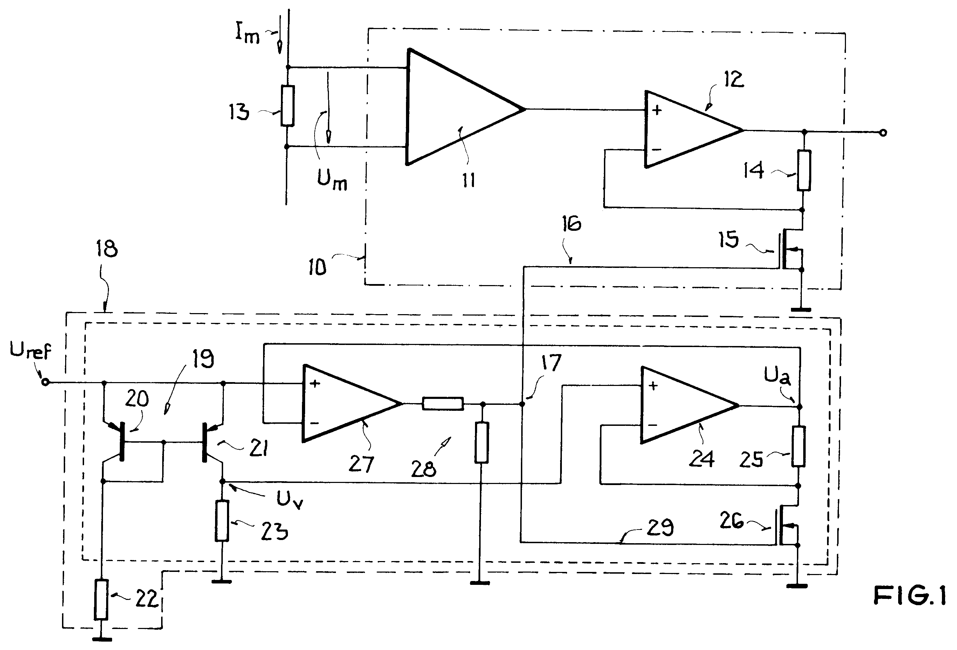

Wie Figur 1 zeigt, weist eine erfindungsgemäße Meßschaltung einen Verstärkerkreis 10 mit einem Meßverstärker 11 und einem Korrekturverstärker 12 auf. Die Eingänge des Meßverstärkers 11 sind mit einem Meßwiderstand 13 verbunden, so daß die infolge eines zu messenden Stromes $I_m$ abfallende Spannung $U_m$ vom Meßverstärker 11 erfaßt und verstärkt wird. Der Ausgang des Meßverstärkers 11 ist mit einem nicht invertierenden Eingang des Korrekturverstärkers 12 verbunden. Der Ausgang des Korrekturverstärkers 12, der gleichzeitig den Ausgang des Verstärkerkreises 10 bildet und an den eine nicht dargestellte Auswerteoder Verarbeitungsschaltung angeschlossen bzw. anschließbar ist, ist über einen Rückkoppelungswiderstand 14 mit einem invertierenden Eingang des Korrekturverstärkers 12 verbunden. Der invertierende Eingang des Korrekturverstärkers 12 ist ferner über einen steuerbaren Widerstand 15, der beispielsweise als Feldeffekttransistor, insbesondere als MOS-Feldeffekttransistor ausgebildet sein kann, mit Masse verbunden.

Der steuerbare Widerstand 15 dient zur Einstellung des Verstärkungsfaktors $V_k$ des Korrekturverstärkers und weist einen Stelleingang 16 auf, der mit einem Stellsignalausgang 17 eines Stellsignalerzeugungsschaltkreises 18 verbunden ist.

Der Stellsignalerzeugungsschaltkreis 18 weist einen Stromspiegel 19 mit zwei parallel geschalteten Transistoren 20, 21 auf. Der erste Transistor 20 ist dabei mit seinem Emitter mit einer Referenzspannung $U_{ref}$ verbunden ist. Der Kollektor des Transistors 20 ist über einen genauen externen Widerstand 22 mit Masse verbunden. Der zweite Transistor 21 ist ebenfalls mit seinem Emitter mit der Referenzspannung $U_{ref}$ verbunden während sein Kollektor über einen Vergleichswiderstand 23 auf Masse geschaltet ist. Die Basisanschlüsse der beiden Transistoren 20, 21 sind mit einander und mit dem Kollektor des ersten Transistors 20 verbunden.

Der Stromspiegel 19 ist dabei so ausgelegt, daß über den zweiten Transistor 21 und den Vergleichswiderstand 23 ein definierter Strom fließt, der am Kollektor des Widerstandes 21 eine Vergleichsspannung $U_V$ bewirkt, die gleich einem definierten Wert von zum Beispiel 2,5 V ist, wenn der tatsächliche Widerstandswert $R_{V,i}$ des Vergleichswiderstandes 23 gleich seinem Nennwiderstandswert $R_{V,n}$ ist. Alle in der Beschreibung verwendeten Zahlenwertangaben stellen nur Beispiele dar, die lediglich dem besseren Verständnis der Erfindung dienen und je nach den konkreten Anforderungen und Ausgestaltungen der Erfindung verändert werden können.

Die Vergleichsspannung $U_V$ am Kollektor des Transistors 21 wird an einen nicht invertierenden Eingang eines Regelverstärkers 24 angelegt, dessen Ausgang über einen Rückkoppelungswiderstand 25 auf seinen invertierenden Eingang zurückgekoppelt ist. Der invertierende Eingang des Regelverstärkers 24 ist weiter über einen steuerbaren Widerstand 26, der beispielsweise als Feldeffekttransistor ausgelegt ist, mit Masse verbunden, so daß durch eine Veränderung des Widerstandswertes des steuerbaren Widerstandes 26 der Verstärkungsfaktor $V_x$ des Regelverstärkers 24 einstellbar ist.

Die Ausgangsspannung $U_a$ $(= V_x \cdot U_V)$ des Regelverstärkers 24, die bei nicht nachgeregeltem Verstärkungsfaktor $V_x = V_0 = 2$ gleich der Referenzspannung $U_{ref}$ $(= 5 \text{ V})$ ist, wenn der Widerstandswert $R_{V,i}$ des Vergleichswiderstandes 23 gleich seinem Nennwiderstandswert $R_{V,n}$ ist und die Vergleichsspannung $U_V$ am Vergleichswiderstand 23 somit 2,5 V beträgt, wird auf einen Eingang einer Vergleichsschaltung 27 geführt, an deren anderem Eingang die Referenzspannung $U_{ref}$ anliegt. Der Ausgang der Vergleichsschaltung 27 ist über einen Spannungsteiler 28 mit Masse verbunden, dessen Mittelabgriff den Stellsignalausgang 17 des Stellsignalerzeugungsschaltkreises 18 bildet. Der Stellsignalausgang 17 ist ferner mit einem Steuereingang 29 des steuerbaren Widerstandes 26 verbunden.

Bis auf den genauen externen Widerstand 22 lassen sich alle Schaltungselemente des Stellsignalerzeugungsschaltkreises 18 gemeinsam mit den Schaltungselementen des Verstärkerkreises 10 auf einem Halbleitersubstrat einer integrierten Schaltung ausbilden.

Zur Regelung bzw. Steuerung der Verstärkungsfaktoren $V_x$ und $V_m$ des Regelverstärkers 24 bzw. des Korrekturverstärkers 12 in Abhängigkeit von der jeweiligen tatsächlichen Fertigungstoleranz wird die am Vergleichswiderstand 23 anliegende Vergleichsspannung $U_V$ in Abhängigkeit von der Fertigungstoleranz verstärkt und dann mit der Referenzspannung $U_{ref}$ verglichen, bis sich am Ausgang die Referenzspannung einstellt.

Die Vergleichsspannung $U_V$ ergibt sich durch den Spannungsabfall am Vergleichswiderstand, der von einem vorgegebenen genauen Strom erzeugt wird. Um diesen genauen Strom zu erhalten, wird in der Reihenschaltung aus dem ersten Transistors 20 und dem genauen externen Widerstand 22 ein definierter Strom eingestellt, der über den Stromspiegel 19 in die integrierte Schaltung auf den Vergleichswiderstand 23 gespiegelt wird. Über den Vergleichswiderstand 23 fließt somit ein im wesentlichen von Toleranzen freier Strom. Damit hängt die Vergleichsspannung $U_V$ am Vergleichswiderstand 23 praktisch nur noch von dessen tatsächlichen Widerstandswert $R_{V,i}$ ab.

Da der tatsächliche Widerstandswert $R_{V,i}$ um $\pm$ 30 % von seinem Nennwiderstandswert $R_{V,n}$ abweichen kann, kann auch die am Vergleichswiderstand 23 bzw. am Kollektor des Transistors 21 abgegriffene Spannung $U_{V,i}$ um $\pm$ 30 % von ihrem Sollwert abweichen. Die Ausgangsspannung $U_a = V_x \cdot U_V$ des Regelverstärkers 24 wird dann mit der Referenzspannung $U_{ref}$ verglichen. Weicht die Ausgangsspannung $U_a$ des Regelverstärker 24 von der Eingangsspannung $U_{ref}$ ab, so wird der Verstärkungsfaktor $V_x$ des Regelverstärkers 24 so eingestellt, daß seine Ausgangsspannung $U_a$ gleich der Eingangsspannung $U_{ref}$ wird. Hierzu wird der Widerstandswert des steuerbaren Widerstandes 26 mittels des von der Vergleichsschaltung 27 gelieferten Stellsignals nachgestellt.

Für den Verstärkungsfaktor $V_x$ des Regelverstärkers 24 gilt dann $V_x = V_0 \cdot 1/(1 \pm \Delta R_V/R_{V,n})$, wobei $V_0$ die typische Verstärkung des nicht nach gestellten Regelverstärkers 24, $\Delta R$ der Betrag der Abweichung des tatsächlichen Widerstandswertes des Vergleichswiderstandes 23 von seinem Nennwiderstandswert $|R_{V,i} - R_{V,n}|$ und $R_{V,n}$ der Nennwiderstandswert des Vergleichswiderstandes 23 ist.

Da das vom Stellsignalerzeugungsschaltkreis 18 erzeugte Stellsignal auch an den steuerbaren Widerstand 15 des Korrekturverstärkers 12 im Verstärkerkreis 10 der Meßschaltung angelegt ist, wird die Verstärkung des Korrekturverstärkers 12 in entsprechender Weise nachgestellt. Für den Verstärkungsfaktor $V_{m,x}$ des Korrekturverstärkers 12 gilt dabei $V_{m,x} = V_{m,0} \cdot 1/(1 \pm \Delta R_m/R_{m,n})$ in entsprechender Weise wie für den Regelverstärker. Da der Meßwiderstand 13 fertigungsbedingt die gleichen Toleranzen aufweist wie der Vergleichswiderstand 23, da also die relative Abweichung $\Delta R_m/R_{m,n}$ des tatsächlichen Widerstandswertes des Meßwiderstandes 13 von seinem Nennwiderstandswert gleich der relativen Abweichung $\Delta R_V/R_{V,n}$ des tatsächlichen Widerstandswertes des Vergleichswiderstandes 23 von seinem Nennwiderstandswert ist, ist die Ausgangspannung $U_k$ des Korrekturverstärkers 12 gleich der an einem toleranzfreien Meßwiderstand abgegriffenen, von einem zu messenden Strom erzeugten und in vorgegebener Weise verstärkten Spannung.

Auf diese Weise läßt sich ein exaktes Meßergebnis auch mit einem mit Toleranzen behafteten Meßwiderstand erreichen, da der Verstärkungsfaktor $V_{m,x}$ des Korrekturverstärkers 12 entsprechend des relativen Fehlers $\Delta R_m/R_{m,n}$ des Widerstandswertes des Meßwiderstands 13 gesteuert wird. Die am fehlerbehafteten Meßwiderstand 13 abgegriffene Meßspannung $U_m$ also so verstärkt, daß der durch die Widerstandstoleranz bewirkte Fehlbetrag kompensiert wird.

Die beschriebene Meßschaltung ermöglicht es somit, einen mit relativ großen Toleranzen behafteten Meßwiderstand zu verwenden, der auf dem Halbleitersubstrat eines integrierten Schaltkreises ausgebildet ist, da seine Toleranzen in der beschriebenen Weise mittels eines die gleichen Toleranzen aufweisenden Vergleichswiderstandes festgestellt und kompensiert werden können.

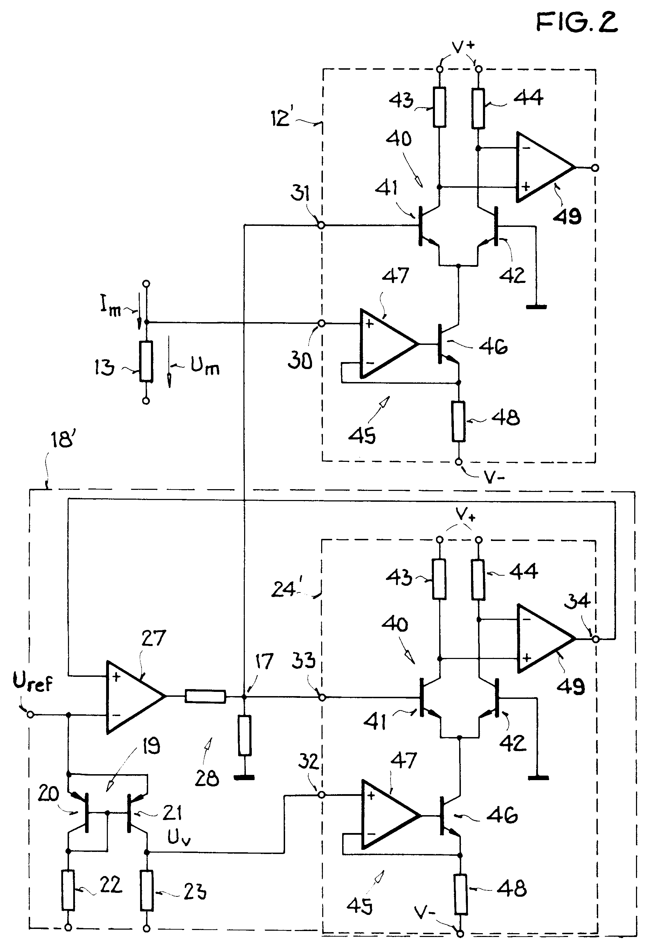

Eine andere Ausgestaltung der erfindungsgemäßen Meßschaltung weist entsprechend Figur 2 einen Meßwiderstand 13 auf, über den ein zu messender Strom $I_m$ geführt wird. Die am Meßwiderstand 13 abgegriffene Meßspannung $U_m$ wird an einen Signaleingang 30 eines Korrekturverstärkers 12' angelegt, an dessen Stelleingang 31 ein Stellsignal anliegt, das von einem Stellsignalausgang 17 eines Stellsignalerzeugungsschaltkreises 18' abgenommen wird, Der Stellsignalerzeugungsschaltkreis 18' umfaßt einen Stromspiegel 19 mit einem ersten und einem zweiten Transistor 20, 21, die jeweils mit einem genauen externen Widerstand 22 bzw. einem auf dem Halbleitersubstrat ausgebildeten Vergleichswiderstand 23 in Reihe geschaltet sind. Die am Vergleichswiderstand 23 abgegriffene Vergleichsspannung $U_V$ ist einem Signaleingang 32 eines Regelverstärkers 24' zugeführt, an dessen Stelleingang 33 das Stellsignal vom Stellsignalausgang 17 anliegt. Zur Erzeugung des Stellsignals ist, wie auch bei der Schaltung nach Figur 1, eine Vergleichsschaltung 27 vorgesehen, deren Ausgang über einen Spannungsteiler 28 mit Masse verbunden ist, wobei der Mittelabgriff des Spannungsteilers 28 den Stellsignalausgang 17 bildet.

Bei dieser Ausgestaltung der erfindungsgemäßen Meßschaltung wird die Verstärkung des Regelverstärkers 24 wiederum so eingestellt, daß die an seinem Ausgang 34 anliegende Spannung gleich der Referenzspannung $U_{ref}$ wird. Da das von der Vergleichsschaltung 27 für den Spannungsteiler 28 gelieferte Stellsignal auch zur Korrektur der Verstärkung des Korrekturverstärkers 12' verwendet wird, wird dessen Verstärkung in entspechender Weise verändert, so daß durch fertigungsbedingte Toleranzen des Meßwiderstandes 13 hervorgerufene Abweichungen der Meßspannung $U_m$ vom zu erwartenden Wert kompensiert werden.

Der Korrekturverstärker 12' und der Regelverstärker 24' sind in gleicher Weise in bipolarer Technik als Elemente eines integrierten Schaltkreises aufgebaut und umfassen eine Steilheits-Multiplizierschaltung. Sowohl der Regelverstärker 24' als auch der Korrekturverstärker 12' weisen einen Differenzverstärkerkreis 40 mit einem ersten und einem zweiten Transistor 41, 42 auf, deren Kollektoren jeweils über einen Widerstand 43, 44 mit einer positiven Versorgungsspannung V+ verbunden sind. Die miteinander verbundenen Emitter der Transistoren 41, 42 sind mit dem Kollektor eines Transistor 46 verbunden, der zusammen mit einem Operationsverstärker 47 und einem Widerstand 48 eine steuerbare Stromquelle 45 bildet. Der Emitter des Transistors 46, dessen Basis vom Ausgang des Operationsverstärkers 47 beaufschlagt wird, ist dabei über den Widerstand 48 an eine negative Versorgungsspannung V- angeschlossen und direkt auf den invertierenden Eingang des Operationsverstärkers 47 zurückgeführt, dessen nicht-invertierender Eingang als Signaleingang 30 bzw. 32 des Korrekturverstärkers 12' bzw. des Regelverstärkers 24' dient.

Die Stelleingänge 31, 33 des Korrekturverstärkers 12' bzw. des Regelverstärkers 24' sind jeweils mit der Basis des ersten Transistors 41 verbunden, während die Basis des zweiten Transistors 42 des Differenzverstärkerkreises 40 an Masse liegt. Die Kollektoren der beiden Transistoren 41, 42 sind mit einem nicht-invertierenden bzw. einem invertierenden Eingang eines weiteren Operationsverstärkers 49 verbunden, dessen Ausgang den Meßsignalausgang des Korrekturverstärkers 12' bzw. den Ausgang 34 des Regelverstärkers 24' bildet.

Hierbei werden also der Korrekturverstärker 12' und der Regelverstärker 24' so betrieben, daß die zu verstärkenden Signale, also das Meßsignal $U_m$ und das Vergleichssignal $U_v$, jeweils zur Steuerung der steuerbaren Sromquelle 45 verwendet werden, während das Stellsignal über die Stelleingänge 31, 33 an die überlicherweise als Eingang des Differenzverstärkerkreises 40 dienenden Basisanschlüsse des Transistors 41 angelegt wird.

Erfindungsgemäß wird also bei der beschriebenen Meßschaltung nach Fig. 2 die Verstärkung für das Meßspannungssignal $U_m$ entsprechend der am Vergleichswiderstand 23 festgestellten tatsächlichen Fertigungstoleranz nachgestellt, wobei das Meßspannungssignal $U_m$ und Vergleichsspannungssignal $U_V$ als Steuersignale an die steuerbaren Stromquellen 45 angelegt werden, während das Stellsignal in Abhängigkeit vom jeweils mittels der steuerbaren Stromquellen 45 eingestellten Ströme verstärkt wird, um die Ausgangssignale des Korrekturverstärkers 12' bzw. des Regelverstärkers 24' zu liefern.

**Patentansprüche**

1. Elektronische Meßschaltung, insbesondere zum Messen von Strömen, mit einem integrierten Meßwiderstand (13), an dem ein einer zumessenden Größe entsprechendes Spannungssignal abgegriffen wird, **dadurch gekennzeichnet, daß**

    a) ein Verstärkerkreis, vorgesehen ist, über den das am Meßwiderstand abgegriffene, verstärkte Spannungssignal als Meßsignal an eine Auswerte- oder Verarbeitungsschaltung anlegbar ist,
    b) der Verstärkerkreis (10; 12') einen steuerbaren Korrekturverstärker (12; 12') aufweist, dessen Verstärkungsfaktor ($V_k$) in Abhängigkeit von der Abweichung ($\Delta R_m$) des tatsächlichen Widerstandswertes ($R_{m,i}$) des Meßwiderstands (13) von seinem Nennwiderstandswert ($R_{m,n}$) gesteuert wird, indem
    c) die Abweichung ($\Delta R_m$) des tatsächlichen Widerstandswertes ($R_{m,i}$) des Meßwiderstands (13) von seinem Nennwiderstandswert ($R_{m,n}$) mit Hilfe eines ebenfalls integrierten Vergleichswiderstands (23) ermittelt wird, wobei die relative Abweichung ($\Delta R_V/R_{V,n}$) seines tatsächlichen Widerstandswertes ($R_{V,i}$) von seinem Nennwiderstandswert ($R_{V,n}$) der relativen Abweichung ($\Delta R_m/R_{m,n}$) des tatsächlichen Widerstandswertes ($R_{m,i}$) des Meßwiderstands (13) von seinem Nennwiderstandswert ($R_{m,n}$) entspricht.

2. Meßschaltung nach Anspruch 1, dadurch **gekennzeichnet,** daß der Vergleichswiderstand (23) zur Erzeugung eines Vergleichsspannungssignals ($U_V$) mit einem mittels einer Konstantstromquelle (19) erzeugten definierten Strom beaufschlagt wird, daß das Vergleichsspannungssignal ($U_V$) mittels eines Verstärkers (24, 24') mit steuerbarem Verstärkungsfaktor ($V_x$) verstärkt wird, daß das Ausgangsspannungssignal ($U_a$) des Verstärkers (24, 24') einem Eingang einer Vergleichsschaltung (27, 28) zugeführt wird, an deren anderem Eingang eine Referenzspannung ($U_{ref}$) anliegt, und daß ein Ausgangssignal der Vergleichsschaltung als Verstärkungssteuersignal sowohl dem Verstärker (24, 24') als auch dem Korrekturverstärker (12,12') zugeführt wird.

3. Meßschaltung nach Anspruch 1 oder 2, dadurch **gekennzeichnet**, daß die Konstantstromquelle eine Stromspiegelschaltung (19) ist, die einen unabhängig von der integrieten Schaltung ausgebildeten, genauen externen Widerstand (22) umfaßt.

4. Meßschaltung nach einem der vorangehenden Ansprüche, dadurch **gekennzeichnet**, daß die Vergleichsschaltung (27, 28) einen Operationsverstärker (27) umfaßt.

5. Meßschaltung nach einem der vorangehenden Ansprüche, dadurch **gekennzeichnet**, daß der Verstärker (24) und der Korrekturverstärker (12) jeweils in gleicher weise von einem Operationsverstärker gebildet sind, dessen Ausgang über einen festen Widerstand (14, 25) auf seinen invertierenden Eingang zurückgekoppelt ist und dessen invertierender Eingang über einen steuerbaren Widerstand (15, 26) mit Masse verbunden ist, wobei dem steuerbaren Widerstand (15, 26) das Verstärkungssteuersignal von der Vergleichsschaltung (27, 28) als Widerstands-Stellsignal zugeführt ist.

6. Meßschaltung nach einem der vorangehenden Ansprüche, dadurch **gekennzeichnet**, daß der Verstärker (24') und der Korrekturverstärker (12') jeweils in gleicher Weise aus einem Differenzverstärker (40) mit zugeordneter steuerbarer Stromquelle (45) gebildet sind, wobei das der zumessenden Größe entsprechende Spannungssignal ($U_m$) vom Meßwiderstand (13) und das Vergleichsspannungssignal ($U_V$) vom Vergleichswiderstand (23) jeweils als Steuersignal an die jeweilige steuerbare Stromquelle (45) angelegt sind, während das Verstärkungssteuersignal von der Vergleichsschaltung (27, 28) jeweils an einen ersten Eingang der Differenzverstärker (40) angelegt ist, deren zweite Eingänge mit einem festen Potential, insbesondere mit Masse verbunden sind.

FIG.1

FIG.2